# EUROPÄISCHE PATENTSCHRIFT

(11) **EP 2 068 158 B1**
(45) Veröffentlichungstag und Bekanntmachung des Hinweises auf die Patenterteilung: **02.12.2015**
(21) Anmeldenummer: 08020948.9
(22) Anmeldetag: 03.12.2008
(51) Int. Cl.: G01R 19/00, G05F 1/565, G01R 31/26

(54) **Vorrichtung zum Messen eines Laststroms**
Apparatus for measuring load current
Appareil de mesure de courant de charge

(30) Priorität: 04.12.2007 DE 102007058314
(43) Veröffentlichungstag der Anmeldung: 10.06.2009
(73) Patentinhaber: Diehl Aerospace GmbH, 88662 Überlingen (DE)
(72) Erfinder: Späh, Jürgen, 88662 Überlingen (DE)
(74) Vertreter: Diehl Patentabteilung

(56) Entgegenhaltungen:
- EP-A1- 1 115 203
- US-A- 5 004 970
- US-A- 5 079 456
- US-A- 5 592 394
- US-A1- 2002 005 738
- US-A1- 2005 275 393
- US-B1- 7 106 042

## Beschreibung

Die Erfindung geht aus von einer Vorrichtung zum Messen eines Laststroms in einem Lastkreis, mit einem Schalter mit einer Kennlinie, der zum Schalten des Laststroms vorgesehen ist und der eine Steuergröße und eine von der Steuergröße abhängige Ausgangsgröße aufweist, einem Stellmittel zum Konstanthalten der Ausgangsgröße auf einem vorbestimmten Wert und einem Auswertemittel zum Ermitteln des Laststroms.

In einem elektrischen Lastkreis mit einer Spannungsquelle und einer damit verbundenen Last, wie einem Motor oder einem anderen Verbraucher, bedarf es eines Schalters zum Ein- und Ausschalten der Last bzw. des Lastkreises. Wird ein diskreter Schalter verwendet und soll der Laststrom im Lastkreis gemessen werden, so wird ein Messelement in den Lastkreis integriert, dessen Messwiderstand einen kleinen Spannungsabfall verursacht, über den der Laststrom ermittelt werden kann.

Aus der DE 197 50 993 A1 ist bekannt, einen niederohmigen Leistungstransistor im Lastkreis, der zum Schutz von Leistungsendstufen vor einer falschen Polung vorgesehen ist, als Messwiderstand zu verwenden. Hierzu wird ein Spannungsabfall über den Leistungstransistor und daraus der Strom im Lastkreis ermittelt.

Eine Schaltung zur Erkennung eines Betriebs einer Last ist in der US 5,004,970 beschrieben. Das Vorhandensein eines Stroms durch die Last erfolgt mithilfe eines Messtransistors, der in Reihe mit einem Messwiderstand geschaltet ist. Fällt die Spannung über den Messwiderstand unter einen Schwellwert, so kann davon ausgegangen werden, dass die Last unterbrochen und der Strom durch die Last zusammengebrochen ist.

Aus der US 5,592,394 ist eine Schaltung bekannt, bei der der Laststrom aus dem Spannungsabfall über den Transistor in Verbindung mit der Steuerspannung am Transistor ermittelt wird.

Es ist die Aufgabe der vorliegenden Erfindung, eine Vorrichtung anzugeben, die besonders geeignet zum Messen eines Laststroms in einem Lastkreis bei einer geringen Spannung an der Last ist.

Diese Aufgabe wird durch eine Vorrichtung der eingangs genannten Art gelöst, bei der erfindungsgemäß das Stellmittel zum Konstanthalten der Ausgangsgröße auf einem vorbestimmten Wert bei veränderlichem Strom durch den Schalter und das Auswertemittel zum Ermitteln des Laststroms aus der Steuergröße vorgesehen ist. Mit dieser Vorrichtung kann der Laststrom durch eine Messung am Schalter ermittelt werden, ohne dass es eines separaten Messelements bedarf.

Die Erfindung geht hierbei von der Überlegung aus, dass bei einer Last, die für eine geringe Spannung ausgelegt ist, auch an einem Messwiderstand nur eine geringe Spannung abfällt. Erfordert die Messung einen vorgegebenen höheren Spannungsabfall, so muss ein Messwiderstand mit entsprechendem hohem Widerstand vorhanden sein. Hierdurch erzeugt der Messwiderstand eine unvorteilhafte Verlustleistung. Durch eine Messung des Laststroms am Schalter kann auf das Messelement und den damit verbundenen Messwiderstand verzichtet werden, und die Verlustleistung des Lastkreises kann gering gehalten werden.

Der Schalter kann im Lastkreis angeordnet sein und ist vorteilhafterweise ein diskreter Schalter mit einer An-Stellung oder einem An-Zustand und einer Aus-Stellung bzw. einem Aus-Zustand. In seiner An-Stellung bzw. An-Zustand weist er zweckmäßigerweise einen geringeren elektrischen Widerstand auf als ein im Lastkreis betriebenes weiteres Element, so dass der Laststrom im Lastkreis von dem weiteren Element bestimmt wird und nicht vom Schalter. Das Element, z. B. die Last, weist somit einen Widerstand auf, der größer ist als der Widerstand des Schalters.

Als Schalter ist jeder Schalter mit einer Steuergröße und einer davon abhängigen Ausgangsgröße geeignet, wobei die Ausgangsgröße - unabhängig von der Diskretheit des Schalters - zweckmäßigerweise in zumindest mehreren Stufen einstellbar ist und insbesondere eine - zumindest im Wesentlichen - kontinuierliche Kennlinie zwischen Steuergröße und Ausgangsgröße aufweist. Hierbei ist der Lastkreis zweckmäßigerweise so ausgelegt, dass der Arbeitspunkt auf der Kennlinie verändert werden kann, ohne dabei von der An-Stellung bzw. dem An-Zustand in die Aus-Stellung bzw. den Aus-Zustand zu wechseln. Insbesondere kann der Arbeitspunkt im überwiegenden Teil des Arbeitsbereichs der Kennlinie verändert werden, ohne dabei von "An" zu "Aus" oder umgekehrt zu wechseln.

Besonders geeignet für einen Schalter mit einer Kennlinie ist ein Transistor, insbesondere ein FET (Feldeffekt-Transistor), von denen ein MOSFET (Metal Oxide Semiconductor FET), insbesondere ein selbstsperrender n-Kanal MOSFET besonders vorteilhaft verwendet wird.

Der Laststrom kann prinzipiell aus der Ausgangsgröße oder der Steuergröße ermittelt werden. So kann der Laststrom besonders einfach aus der Schalterspannung ermittelt werden, bei einem FET aus der Spannung zwischen Drain uns Source bzw. Drainspannung. Hierbei wird die Steuergröße, z. B. die Spannung zwischen Gate und Source bzw. Gatespannung, konstant gehalten. Aus dem bekannten Zusammenhang zwischen Steuergröße, Schalterspannung und Laststrom kann der Laststrom ermittelt werden.

Gemäß der Erfindung ist jedoch das Auswertemittel zum Ermitteln des Laststroms aus der Steuergröße vorgesehen, im Falle eines FET aus der Gatespannung. In diesem Fall kann die Ausgangsgröße eine Spannung über den Schalter sein und das Stellmittel ist zum Konstanthalten der Spannung über den Schalter vorgesehen. So kann bei Verwendung eines FET als Schalter die Drainspannung konstant gehalten werden und der Laststrom wird aus dem bekannten Zusammenhang zwischen Steuergröße, Schalterspannung und Laststrom ermittelt.

Die Ausgangsgröße, insbesondere die Schalterspannung, kann besonders einfach konstant gehalten werden, wenn das Stellmittel eine Regelschleife zum Konstanthalten der Ausgangsgröße aufweist. Hierbei kann die konstant zu haltende Ausgangsgröße als Regeleingang verwendet werden, wobei der Regelausgang die Steuergröße bestimmt. Insbesondere ist der Regelausgang die Steuergröße. Über eine Referenzgröße, beispielsweise eine Referenzspannung, kann der Wert der konstant einzustellenden Ausgangsgröße eingestellt werden.

In einer vorteilhaften Ausführungsform der Erfindung ist das Auswertemittel dazu vorgesehen, aus der Ausgangsgröße einen Aktivitätszustand des Schalters zu ermitteln. So kann die konstant gehaltene Ausgangsgröße daraufhin diskret abgefragt oder dauerhaft überwacht werden, ob sie den eingestellten konstanten Wert einhält oder trotz eines Mechanismus zur Konstanthaltung den Wert dauerhaft nicht einhält. Dies kann auf einen Überlastzustand des Schalters hinweisen und als ein Kriterium für ein Abschalten des Laststroms verwendet werden. Hierdurch würde als Aktivitätszustand ein Überlastzustand erfasst werden. Als weiterer Aktivitätszustand kann ein Status des Schalters erfasst werden, z. B. ob der Schalter "An" oder "Aus" ist, beispielsweise indem abgefragt oder überwacht wird, ob die Ausgangsgröße den konstanten Wert aufweist oder z. B. auf Null ist. Zusätzlich kann die Ausgangsgröße abgefragt oder überwacht und aus ihrem Wert der Aktivitätszustand ermittelt werden. Liegt die Ausgangsgröße z. B. auf Null oder in einer Sättigung, kann auf eine Stromabschaltung bzw. das Vorliegen einer Überlast geschlossen werden.

Vorteilhafterweise ist das Auswertemittel dazu vorgesehen, die konstant gehaltene Ausgangsgröße zu überwachen und bei einer vorbestimmten Abweichung von der Konstanz ein Signal abzugeben. Wie oben beschrieben, kann eine Überlast des Schalters und/oder der Last im Lastkreis erkannt werden. Mit der Abgabe des Signals, z.B. eines Überlastsignals, kann einem Defekt im Lastkreis zuverlässig entgegengewirkt werden.

Je nach Auslegung des Schalters und der Last im Lastkreis kann es vorkommen, dass die Steuergröße bei konstant gehaltener Ausgangsgröße in die Sättigung geht, ohne dass eine Überlastabschaltung von Schalter oder Last notwendig wäre. Bei einem solchen Zustand kann der Laststrom nicht mehr zuverlässig von dem Wert der Steuergröße ermittelt werden, da dieser in der Sättigung liegt. Um in diesem Zustand dennoch zuverlässig den Laststrom ermitteln zu können, ist das Auswertemittel in einer weiteren vorteilhaften Ausgestaltung der Erfindung dazu vorgesehen, den Laststrom aus sowohl der Ausgangsgröße als auch der Steuergröße zu ermitteln. Liegt die Steuergröße in der Sättigung, so wird die Ausgangsgröße nicht konstant gehalten werden können, so dass ihr Wert in Verbindung mit dem Wert der Steuergröße ein Anzeiger für den Laststrom ist. Auf diese Weise kann auch im Sättigungsbereich des Schalters der Laststrom zuverlässig ermittelt werden.

Wenn der Laststrom im Lastkreis sehr klein ist, kann es - je nach Kennlinie des Schalters - sein, dass die Steigung der Steuergröße in Abhängigkeit von der Ausgangsgröße sehr flach ist. Bei einer solchen Konstellation muss die Steuergröße mit sehr hoher Auflösung ausgewertet werden, um den Laststrom mit hoher Genauigkeit ermitteln zu können. Um in diesem Fall mit einer geringeren Auflösung auskommen zu können, ist es vorteilhaft, wenn der Arbeitspunkt oder Arbeitsbereich auf der Kennlinie bei dem momentanen geringen Strom so gesetzt wird, dass die Kennlinie in diesem Arbeitspunkt bzw. Arbeitsbereich steiler ist. Hierzu ist das Stellmittel vorteilhafterweise dazu vorgesehen, den Arbeitsbereich auf der Kennlinie in Abhängigkeit vom Laststrom einzustellen. Dies kann besonders einfach geschehen, wenn die konstant zu haltende Ausgangsgröße in Abhängigkeit vom Laststrom eingestellt wird, z.B. indem eine Referenzgröße so eingestellt wird, dass mit der konstant zu haltenden Ausgangsgröße ein vorteilhafter Arbeitspunkt bzw. Arbeitsbereich erreicht wird.

Fällt der Laststrom während des Betriebs des Lastkreises bis in einen flachen Bereich der Kennlinie ab, ist es vorteilhaft, den Arbeitspunkt - bei einem momentanen bzw. konstante Laststrom - sofort oder zügig in einen steileren Bereich der Kennlinie zu verlegen. Hierzu ist das Stellmittel vorteilhafterweise dazu vorgesehen, den Wert der konstant gehaltenen Ausgangsgröße, bei Unterschreiten des Laststroms unter einen vorbestimmten Wert abzusenken.

Insbesondere bei hohem Laststrom ist es vorteilhaft, wenn der Schalter einen geringen Widerstand aufweist. Um den Widerstand des Schalters gering zu halten weist dieser vorteilhafterweise parallel geschaltete Schaltelemente auf, beispielsweise zwei parallel geschaltete Schaltelemente, wobei die Ausgangsgröße und Steuergröße beider Schaltelemente gleich behandelt werden. Zur Ermittlung des Laststroms wird die Ausgangsgröße zweckmäßigerweise bei beiden Elementen konstant gehalten.

Vorteilhafterweise ist das zweite Schaltelement zum bereits im Betrieb befindlichen ersten Schaltelement zuschaltbar, z.B. bei einem momentanen hohen Laststrom.

In einer weiteren vorteilhaften Ausführungsform der Erfindung ist im Stromkreis eine aktive Diode mit einer Sperrdiode zum Schutz des Schalters gegen Verpolung angeordnet. Je nach Art des Schalters zum Schalten des Laststroms ist der Schalter empfindlich gegen eine Verpolung, die bei einer fehlerhaft entstandenen Spannung, z.B. durch einen Defekt oder einen Blitzschlag, auftreten kann. Die Sperrdiode ist so im Stromkreis angeordnet, dass ihre Durchlassrichtung der Stromrichtung des Lastkreises bei normalem Betrieb entspricht. Bei einer Verpolung würde ein gegenläufiger Strom in Sperrrichtung der Sperrdiode fließen, der von der Sperrdiode gesperrt wird. Die aktive Diode kann ein Feldeffekttransistor (FET) mit einer internen Substratdiode sein, z.B. ein MOSFET.

Eine besonders einfache Schaltung mit niedrigem Strommesswiderstand und hoher Sicherheit gegen Verpolung kann erreicht werden, wenn die aktive Diode Teil einen weiteren Schalter bildet, der baugleich zum Schalter zum Schalten des Laststroms ist. Der weitere Schalter ist in Bezug auf die Stromrichtung zweckmäßigerweise andersherum im Stromkreis angeordnet als der Schalter zum Schalten des Laststroms. Durch den Schalter kann die Sperrdiode vorteilhafterweise überbrückt werden, so dass der Laststrom bei regulärem Betrieb der Vorrichtung durch den Schalter fließen kann und nicht durch die Sperrdiode muss. Hierdurch kann der Widerstand, der mit einem Stromfluss durch die Sperrdiode in Durchlassrichtung verbunden ist, bei regulärem Betrieb, z.B. mit einem Strom oberhalb eines Grenzwerts, vermieden werden.

Der Schalter zum Überbrücken der Sperrdiode wird vorteilhafterweise geöffnet, sobald die Gefahr einer Verpolung gegeben ist. Die Gefahr einer Verpolung besteht, wenn der Strom durch den Lastkreis gegen Null geht. Eine Stromüberwachung kann somit zum Schalten des weiteren Schalters verwendet werden. Hierzu umfasst die Vorrichtung vorteilhafterweise ein Steuermittel zum Schalten des weiteren Schalters, das dazu vorgesehen ist, den Schalter in Abhängigkeit des vom Auswertemittel gemessenen Stroms zu schalten.

Der Schalter kann geöffnet werden, sobald der Strom im Lastkreis gegen Null geht. Zum Erhöhen der Sicherheit kann der Schalter bereits geöffnet werden, wenn der Strom unter eine Grenzwert fällt. Bei geringem Strom ist der Widerstand der Sperrdiode in Durchlassrichtung gering, so dass er nur wenig nachteilig ist. Hierzu ist das Steuermittel zweckmäßigerweise dazu vorgesehen, die Diode bei einem Stromfluss durch den Lastkreis ab einen vorbestimmten Grenzwert zu überbrücken und den Schalter bei einem Stromfluss unterhalb des Grenzwerts zu öffnen.

Die Erfindung ist außerdem gerichtet auf ein Verfahren zum Messen eines Laststroms in einem Lastkreis, der einen Schalter aufweist, der zum Schalten des Laststroms vorgesehen ist und der eine Steuergröße und eine von der Steuergröße abhängige Ausgangsgröße aufweist, wobei ein Stellmittel die Ausgangsgröße auf einem vorbestimmten Wert konstant hält und ein Auswertemittel den Laststrom aus der Steuergröße ermittelt. Vorteilhafte Ausführungsformen des Verfahrens sind mit oben beschriebenen Merkmalen erreichbar.

Weitere Vorteile ergeben sich aus der folgenden Zeichnungsbeschreibung. In der Zeichnung sind Ausführungsbeispiele der Erfindung dargestellt. Die Zeichnung und die Beschreibung enthalten zahlreiche Merkmale in Kombination, die der Fachmann zweckmäßigerweise auch einzeln betrachten und zu sinnvollen weiteren Kombinationen zusammenfassen wird.

### Es zeigen:

- Fig. 1: einen vereinfachten Schaltplan einer Vorrichtung zum Messen eines Laststroms in einem Lastkreis mit einem Schalter,
- Fig. 2: Diagramme des Laststroms, der Steuergröße und Ausgangsgröße des Schalters und Aktivitätszustandssignale, jeweils über die Zeit,
- Fig. 3: Diagramme wie in Fig. 2, jedoch mit weiteren Aktivitätszuständen,
- Fig. 4: ein Blockschaltbild der Vorrichtung,
- Fig. 5: ein Blockschaltbild einer zur Vorrichtung aus Fig. 3 analogen Vorrichtung mit einer aktiven Diode mit einem weiteren Schalter und
- Fig. 6: ein Diagramm des Laststroms und eines Steuersignals zum Schalten des weiteren Schalters.

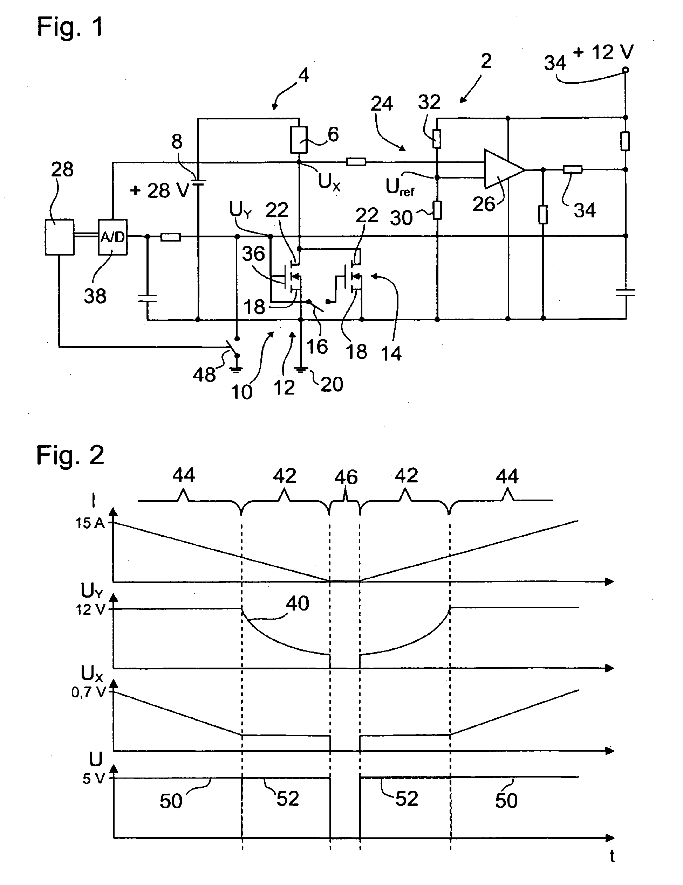

In Fig. 1 ist ein vereinfachter Schaltplan einer Vorrichtung 2 zum Messen eines Laststroms I in einem Lastkreis 4 dargestellt. Die Vorrichtung 2 umfasst den Lastkreis 4, in dem eine Last 6 angeordnet ist, beispielsweise ein Motor, und der eine Spannungsversorgung 8 aufweist. Zum Ein- und Ausschalten des Laststroms I ist der Lastkreis 4 mit einem Schalter 10 versehen, der zwei, jeweils als MOSFET ausgeführte Schaltelemente 12, 14 aufweist. Durch einen Schalter 16 kann das Schaltelement 14 parallel zum Schaltelement 12 geschaltet werden, wobei deren Source 18 mit einer Erdung 20 und deren Drain 22 mit der Last 6 verbunden ist.

Zur Messung des Laststroms I umfasst die Vorrichtung 2 außerdem ein Stellmittel 24 in Form einer Regelschleife zum Konstanthalten der Ausgangsgröße des Schalters 10, in diesem Fall der Ausgangsgröße des Schalters 10 in Form einer Schalterspannung U_{X} über den Schalter 10, also des Spannungsabfalls zwischen dem Drain 22 und Source 18. Herzstück des Stellmittels 24 ist ein Operationsverstärker 26, auch ein Komparator wäre möglich, dessen Eingänge einerseits mit dem Schalter 10 verbunden sind, in diesem Ausführungsbeispiel mit dem Drain 22 des Schalters 10, und andererseits mit einer Referenzspannung U_{ref}. Die Referenzspannung U_{ref} ist von einem Auswertemittel 28 einstellbar, so dass eine steuerbare Referenzquelle vorliegt. Die Steuerbarkeit kann beispielsweise durch einen D/A-Wandler erreicht werden, dessen Digitaleingang mit dem Auswertemittel 28 verbunden ist und dessen Analogausgang die Referenzquelle bildet. Ebenfalls möglich ist ein Spannungsteiler, wie beispielsweise in Fig. 1 dargestellt ist. Hierbei ist das Auswertemittel 28 mit zwei einstellbaren Widerständen 30, 32 verbunden, wobei diese Verbindungen in Fig. 1 der Übersichtlichkeit halber nicht dargestellt sind. Die Widerstände 30, 32 sind zwischen einer Steuerspannungsversorgung 34 und der Erdung 20 angeordnet, so dass das Potential der Referenzspannung U_{ref} zwischen dem Potential der Steuerspannungsversorgung 34 und der Erdung 20 durch das Auswertemittel 28 wählbar ist.

Der Regelausgang liefert die Steuergröße des Schalters 10. Hierfür ist in diesem Ausführungsbeispiel der Ausgang des Operationsverstärkers 26 (über einen weiteren Widerstand) mit dem Gate 36 des Schalters 10 verbunden und liefert die Gatespannung U_{Y}. Zur Ermittlung des Laststroms I aus der Steuergröße ist der Regelausgang - über einen A/D-Wandler 38 - mit dem Auswertemittel 28 verbunden. Ein Tiefpass mit einem Widerstand und einem Kondensator vor dem A/D-Wandler 38 dient zur Entstörung des Regelausgangs, insbesondere um bei Verwendung eines Komparators dessen Signalschwankungen herauszufiltern.

Außerdem ist die Ausgangsgröße des Schalters 10 in Form der Schalterspannung U_{X}, wiederum über den A/D-Wandler 38, in das Auswertemittel 28 geführt, um eine Ermittlung des Laststroms I aus der Gatespannung U_{Y} und der Schalterspannung U_{X} ermitteln zu können. Zur Ansteuerung des Schalters 16 ist das Auswertemittel 28 auch mit diesem verbunden.

Fig. 2 zeigt Diagramme des Laststroms I, der Steuergröße in Form der Gatespannung U_{Y}, der Ausgangsgröße in Form der Schalterspannung U_{X} und Aktivitätszustandssignale 50, 52. Die Diagramme sind zur Verdeutlichung der Größen über der Zeit t aufgetragen.

Im obersten Diagramm ist der Laststrom durch die Last 6 und den Schalter 10 über der Zeit t aufgetragen. Um alle Aktivitätszustände des Schalters 10 zu verdeutlichen, ist der Laststrom I - entgegen der üblichen Lebensrealität - so geführt, dass er sich von einem hohen Wert, in diesem Beispiel 15 A, linear auf Null und wieder auf einen hohen Wert verändert. Im Betrieb kann der Laststrom I selbstverständlich auch jeden anderen Verlauf nehmen.

Im zweiten Diagramm ist die Gatespannung U_{Y} über den gleichen Zeitverlauf aufgetragen, so dass die Beziehung zwischen Laststrom I und Gatespannung U_{Y} sichtbar wird. Diese Beziehung ergibt sich aus der Kennlinie 40 des Schalters 10 und daraus, dass die Regelschleife versucht, zu jedem Zeitpunkt und jedem dann gerade vorliegenden Laststrom I die Schalterspannung U_{X} konstant zu halten und die Gatespannung U_{Y} entsprechend einstellt. Anhand der Gatespannung U_{Y} sind drei Aktivitätszustände 42, 44, 46 des Schalters 10 erkennbar. In einem ersten Aktivitätszustand 42 bzw. einem ersten Steuerbereich des Laststroms I verläuft die Gatespannung U_{Y} in einem Arbeitsbereich zwischen etwa 3 V und 12 V. In diesem Arbeitsbereich weist der Laststrom I Werte zwischen 0 A und etwa 5 A auf.

Steigt der Laststrom I über diesen Steuerbereich, also über etwa 5 A, so ist der Schalter 10 im Aktivitätszustand 44, einem Überlastbereich, in dem die Last 6 und der Schalter 10 zwar ggf. betrieben werden können, die Gatespannung U_{Y} jedoch nicht so verändert werden kann, dass die Schalterspannung U_{X}, die im dritten Diagramm dargestellt ist, konstant gehalten wird. Die Schalterspannung U_{X} steigt linear mit dem Laststrom I an. In einem dritten Aktivitätszustand 46 ist ein in Fig. 1 dargestellter Schalter 48 geöffnet und die Gatespannung U_{Y} ist auf Erdpotential bzw. Nullpotential gelegt und es fließt kein Laststrom I: Der Schalter 10 ist offen bzw. in "Aus-Stellung". Im dritten Aktivitätszustand 46 ist der Status des Schalters 10 daher "Aus", wohingegen der Status des Schalters 10 in den Aktivitätszuständen 42 und 44 "An" ist.

Im vierten Diagramm sind Aktivitätszustandssignale 50, 52 dargestellt, die beispielsweise vom Auswertemittel 28 erzeugt werden. Das Aktivitätszustandssignal 50 ist das Signal des Status des Schalters 10 und gibt an, ob der Schalter 10 "An" oder "Aus" ist. Das Aktivitätszustandssignal 52 zeigt an, ob der Schalter 10 im Steuerbereich oder im Überlastbereich ist, in dem der Schalter 10 immer noch "An" ist.

Während des Betriebs der Vorrichtung 2 kann zunächst der Lastkreis 4 in Betrieb genommen werden, indem der Schalter 10 schließt, also in seine "An-Stellung" schaltet. Dies wird durch das Auswertemittel 28 vorgenommen, wobei auch ein anderes Steuermittel möglich ist, das den Schalter 48 schließt und durch eine entsprechende Ansteuerung der Widerstände 30, 32 eine Referenzspannung U_{ref} einstellt. Hierdurch wird der Laststrom im Lastkreis 4 freigegeben, der sich entsprechend dem Widerstand der Last 6 bzw. aller Bauelemente im Lastkreis 4 einstellt. Hierbei weist der Schalter 10 im Betrieb einen Widerstand auf, der wesentlich kleiner ist als derjenige der Last 6, beispielsweise nur maximal 1/100, insbesondere nur maximal 1/1000 des Widerstands der Last 6 im Steuerbereich.

Durch den Regelkreis wird nun die Schalterspannung U_{X} auf dem Potential der Referenzspannung U_{ref} konstant gehalten, wobei sich eine Gatespannung U_{Y} entsprechend der im zweiten Diagramm dargestellten Kennlinie 40 einstellt. Diese Gatespannung U_{Y} wird vom Auswertemittel 28 erfasst, die daraus aus der bekannten Kennlinie 40 bei vorgegebener Schalterspannung U_{X} den Laststrom I ermittelt. Hierzu ist im Auswertemittel 28 eine Zuordnung von Steuergröße, in diesem Fall der Gatespannung U_{Y}, zu Laststrom I, insbesondere in Abhängigkeit der Ausgangsgröße, in diesem Fall der Schalterspannung U_{X}, hinterlegt.

Steigt der Laststrom I, beispielsweise auf Anforderung der Last 6, in den Überlastbereich an, so kann das Stellmittel 24 die Schalterspannung U_{X} nicht auf dem vorgegebenen Wert konstant halten. Die Schalterspannung U_{X} wird gegen die Regelung über den Wert ansteigen. Um diesen Zustand zu erkennen, überwacht das Auswertemittel 28 die Schalterspannung U_{X} und gibt bei einer vorbestimmten Abweichung der Schalterspannung Ux vom vorgegebenen Wert ein Signal aus, z. B. eine Änderung des Aktivitätszustandssignals 52 von "An" nach "Aus".

Außerdem reicht im Überlastbereich eine Auswertung der Gatespannung U_{Y} für eine Ermittlung des Laststroms nicht aus. Vielmehr ist die Gatespannung U_{Y} in diesem Status 44 des Schalters 10 konstant. Jedoch steht der Laststrom I in einem eindeutigen Zusammenhang mit beiden Schaltergrößen, also Gatespannung U_{Y} und Schalterspannung U_{X}, so dass das Auswertemittel 28 im Überlastbereich den Laststrom aus beiden Schaltergrößen ermittelt.

Um den Widerstand des Schalters 10 niedrig zu halten, kann das zweite Schaltelement 14 durch das Auswertemittel 28 aktiviert werden, indem der Schalter 16 geschlossen wird. Diese Option steht nicht nur im Aktivitätszustand 44, sondern auch im Normalbetrieb zur Verfügung, um die Verlustleistung im Schalter 10 gering zu halten.

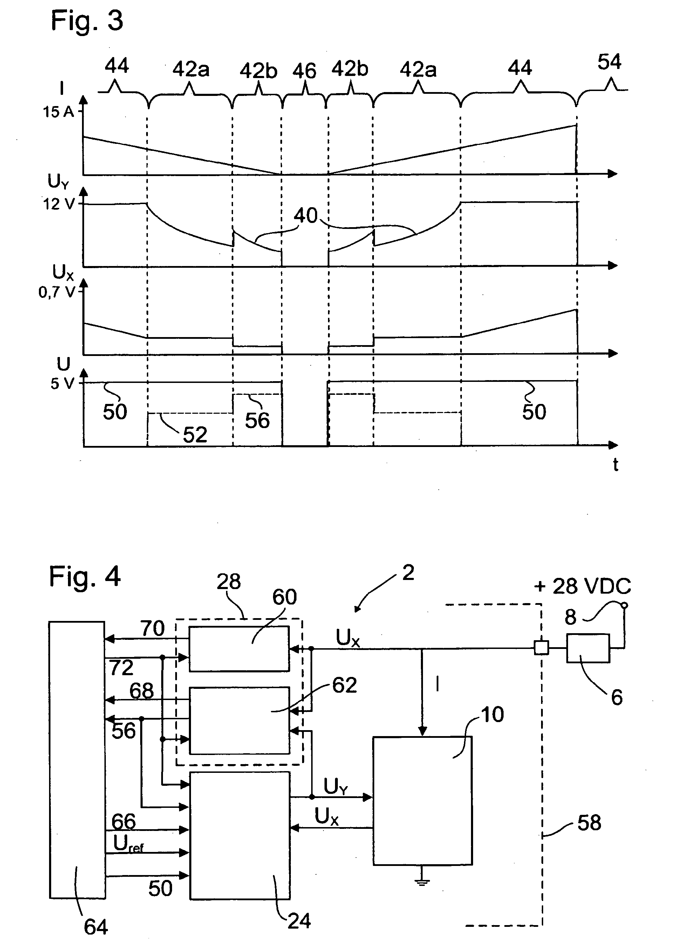

Fig. 3 zeigt Diagramme wie Fig. 2, jedoch mit einer veränderten Steuerung durch das Auswertemittel 28, wodurch der Aktivitätszustand 42 in zwei Aktivitätszustände 42a und 42b aufgeteilt und ein neuer Aktivitätszustand 54 geschaffen wird. Der Aktivitätszustand 42b dient zum Messen des Laststroms I im Bereich geringer Ströme. Fällt der Laststrom I im Lastkreis 4 unter einen im Auswertemittel 28 hinterlegten Wert, z. B. unter 200 mA, so wird vom Auswertemittel 28 ein Aktivitätszustandsignal 56 ausgegeben und die Referenzspannung U_{ref}, die zum Konstanthalten der Schalterspannung U_{X} vom Auswertemittel 28 ebenfalls konstant gehalten wird, wird abgesenkt, z. B. von 100 mV auf 50 mV. Durch das Absenken der Referenzspannung U_{ref} wird die Gatespannung U_{Y} vom Regelkreis so geregelt, dass sich die Schalterspannung U_{X} auf den Wert der Referenzspannung U_{ref} einstellt, also ebenfalls abgesenkt wird. Hierdurch liegt der Arbeitspunkt der Gatespannung U_{Y} in einem Bereich der Kennlinie 40 größerer Steilheit, so dass die Auflösung zum Messen des Laststroms I größer wird. Es wird also die Kennlinie 40 in der Weise verschoben, dass der Arbeitspunkt auf der Kennlinie 40 - im Falle eines schwankenden Laststroms I ein Arbeitsbereich auf der Kennlinie 40 - steiler wird. Durch die höhere Steigung der Kennlinie 40 kann der Laststrom I ohne apparativen Mehraufwand genauer ermittelt werden.

Hierdurch wird allerdings auch der Laststrombereich kleiner, so dass nur geringere Lastströme I anhand der Gatespannung U_{Y} gemessen werden können. Es ist daher vorteilhaft, wenn die Schalterspannung U_{X} vom Auswertemittel 28 bei Ansteigen des Laststroms I über den vorbestimmten Wert wieder angehoben wird durch Anheben der Referenzspannung U_{ref}, so dass der Schalter 10 den Aktivitätszustand 42a wieder annimmt. Um ein Flackern der Aktivitätszustände 42a, 42b zu vermeiden, kann eine Hysterese vorgesehen sein, die einen bei einem Wert W umgeschalteten Aktivitätszustand 42a, 42b erst bei dem Wert von beispielsweise W + 20 mV oder W - 20 mV, je nach Umschaltrichtung, wieder zurück schaltet.

Steigt der Laststrom I durch die Last 6 weiter an, so dass der Überlastbereich erreicht wird, so wird dies vom Auswertemittel 28 zwar durch einen Wechsel vom Aktivitätszustand 42a in den Aktivitätszustand 44 registriert, der Schalter 10 jedoch nicht geöffnet zum Unterbrechen des Laststroms I. Dies geschieht erst, wenn der Laststrom I über einen weiteren vorbestimmten Wert steigt, z. B. 12 A, und damit den Aktivitätszustand 54 erreicht. Bei Erreichen des Aktivitätszustands 54 wird das Aktivitätszustandssignal 50 vom Auswertemittel 28 geändert, z. B. auf Null gesetzt, und damit der Schalter 48 geöffnet und die Gatespannung U_{Y} hierdurch auf Null gelegt, so dass der Schalter 10 den Laststrom I sperrt.

In Fig. 4 ist das Prinzip der Erfindung in einem vereinfachten Blockschaltbild dargestellt. In einem Gehäuse 58 ist die Vorrichtung 2 angeordnet, in diesem Ausführungsbeispiel ohne die Last 6 und die Spannungsversorgung 8, die außerhalb des Gehäuses 58 gelegen sind. Durch den Schalter 10 fließt der Laststrom I, wodurch die Schalterspannung U_{X} von einem Spannungsmonitor 60 des Auswertemittels 28 abgegriffen werden kann. Von einem Strommonitor 62 des Auswertemittels 28 wird die Steuergröße, in diesem Fall die Gatespannung U_{Y}, überwacht, wobei zur Bestimmung des Laststroms I im Überlastbereich auch die Schalterspannung U_{X} in den Strommonitor 62 eingegeben ist. Das Stellmittel 24, in diesem Fall die Regelschleife, erhält als Regeleingang die Schalterspannung U_{X} und gibt die Gatespannung U_{Y} aus.

In diesem Ausführungsbeispiel wird die Steuerung der Regelschleife und des Schalters 10 nicht vom Auswertemittel 28 sondern von einem Steuermittel 64 vorgenommen, das die Referenzspannung U_{ref}, einen Reset des Schalter 48 mit dem Aktivitätszustandssignal 50 und ein Commandsignal 66 zur Steuerung des Stellmittels 24 ausgibt. Es ist auch möglich, das Auswertemittel 28 im Steuermittel 64 zu integrieren oder umgekehrt. Die Aktivitätszustandssignale 52, 56 bezüglich des Überlastbereichs und des Kleinlastbereichs werden vom Strommonitor 62 ausgegeben; ebenso das Signal 68 des momentanen Laststroms I. Das Signal 70 der momentanen Schalterspannung U_{X} wird vom Spannungsmonitor 60 an das Steuermittel 64 übertragen, das in einem Signal 72 den Spannungsmonitor 60, den Strommonitor 62 und das Stellmittel 24 konfiguriert.

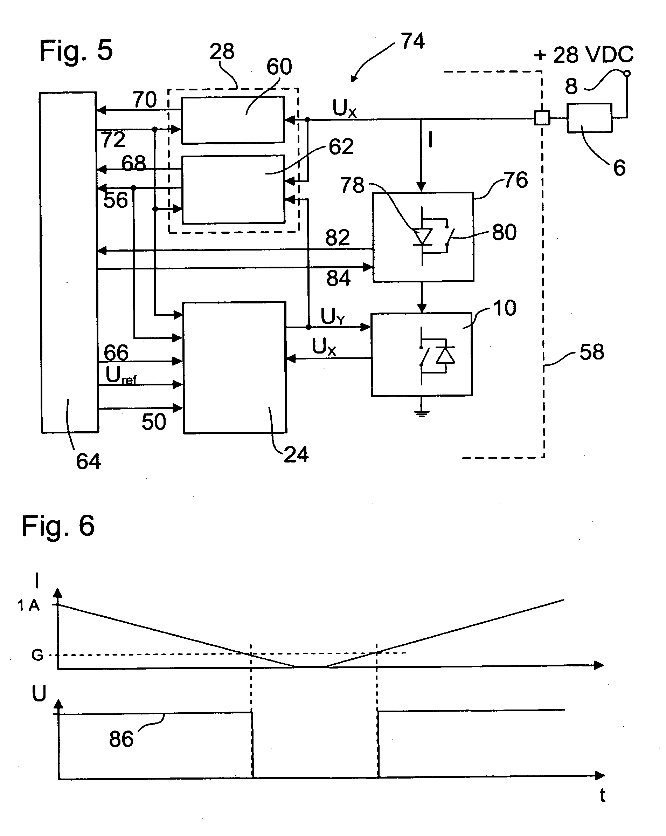

Fig. 5 zeigt eine Vorrichtung 74, die zur Vorrichtung 2 vollständig identisch ist, jedoch zusätzlich eine aktive Diode 76 im Lastkreis 4 aufweist. Die aktive Diode 76 ist wie der Schalter 10 als MOSFET ausgeführt, jedoch ist in Bezug zur Stromrichtung im Lastkreis 4 entgegengesetzt zum Schalter 10 angeordnet, wie durch die symbolische Kennzeichnung der aktiven Diode 76 und des Schalter 10 in Fig. 5 angedeutet ist. Die aktive Diode 76 umfasst eine Sperrdiode 78 und einen weiteren Schalter 80, mit dem die Sperrdiode 78 überbrückbar ist. Durch entsprechende Signalverbindungen 82, 84 vom Steuermittel 64 zur aktiven Diode 76 und von der aktiven Diode 76 zum Steuermittel 64 wird der Schalter 80 vom Steuermittel 64 auf sein Stellung hin überwacht und in Bezug auf seine Stellung gesteuert. Die Steuerung erfolgt in Abhängigkeit vom Strom I durch den Lastkreis 4 bzw. durch den Schalter 10 wie er vom Auswertemittel 28 erfasst wird.

Fig. 6 zeigt ein Diagramm des Laststroms I über der Zeit t analog zu Fig. 2. Auch hier ist der Verlauf des Laststroms I entgegen der üblichen Lebensrealität so geführt, dass die Aktivitätszustände des Schalters 80 verdeutlicht werden können. Oberhalb eines Grenzwerts G des Laststroms I, z.B. oberhalb 50 mA, ist ein Steuersignal 86 vom Steuermittel 64 an die aktive Diode 76 so gehalten, dass der Schalter 80 geschlossen ist, so dass der Laststrom I durch den Schalter 80 fließt. Ein nachteilig hoher Widerstand der Sperrdiode 78 wegen eines durch fließenden hohen Laststroms I kann vermieden werden.

Erreicht der Laststrom I den Grenzwert oder fällt unter ihn ab, so steuert das Steuermittel 64 das Steuersignal 86 auf einen anderen Wert, z.B. auf 0 V im Gegensatz zu z.B. 5 V bei geschlossenem Schalter 80. Dies bewirkt das sofortige Öffnen des Schalters 80, so dass der nunmehr geringe Laststrom, z.B. von oder unter 50 mA, durch die Sperrdiode 78 fließt, dort jedoch nur eine sehr geringe Wärmeerzeugung bewirkt. Fällt der Laststrom I weiter, wird sein Fließen durch die Sperrdiode 78 gesteuert, die eine Richtungsumkehr des Laststroms I sperrt und somit den Schalter 10 vor einer Verpolung schützt. Steigt der Laststrom I wieder über auf oder über den Grenzwert G an, so ändert sich das Steuersignal 86 wieder in das Freigabesignal, der Schalter 80 wird wieder geschlossen und die Sperrdiode 78 somit überbrückt.

### Bezugszeichenliste

- 2: Vorrichtung
- 4: Lastkreis
- 6: Last
- 8: Spannungsversorgung
- 10: Schalter
- 12: Schaltelement
- 14: Schaltelement
- 16: Schalter
- 18: Source
- 20: Erdung
- 22: Drain
- 24: Stellmittel
- 26: Operationsverstärker
- 28: Auswertemittel
- 30: Widerstand
- 32: Widerstand
- 34: Steuerspannungsversorgung
- 36: Gate
- 38: A/D-Wandler
- 40: Kennlinie
- 42: Aktivitätszustand
- 44: Aktivitätszustand
- 46: Aktivitätszustand
- 48: Schalter
- 50: Aktivitätszustandssignal
- 52: Aktivitätszustandssignal
- 54: Aktivitätszustand
- 56: Aktivitätszustandsignal
- 58: Gehäuse
- 60: Spannungsmonitor
- 62: Strommonitor
- 64: Steuermittel
- 66: Commandsignal
- 68: Signal
- 70: Signal
- 72: Signal
- 74: Vorrichtung
- 76: Diode
- 78: Sperrdiode
- 80: Schalter
- 82: Signalverbindung
- 84: Signalverbindung
- 86: Steuersignal
- I: Laststrom
- G: Grenzwert
- U_{ref}: Referenzspannung
- U_{X}: Schalterspannung
- U_{Y}: Gatespannung

## Patentansprüche

1. Vorrichtung (2, 74) zum Messen eines Laststroms (I) in einem Lastkreis (4), mit einem Schalter (10) mit einer Kennlinie (40), der zum Schalten des Laststroms (I) vorgesehen ist und der eine Steuergröße und eine von der Steuergröße abhängige Ausgangsgröße aufweist, einem Stellmittel (24) zum Konstanthalten der Ausgangsgröße auf einem vorbestimmten Wert und einem Auswertemittel (28) zum Ermitteln des Laststroms (I),
**dadurch gekennzeichnet,**
**dass** das Stellmittel (24) zum Konstanthalten der Ausgangsgröße auf einem vorbestimmten Wert bei veränderlichem Strom durch den Schalter (10) und das Auswertemittel (28) zum Ermitteln des Laststroms (I) aus der Steuergröße vorgesehen ist.

2. Vorrichtung (2, 74) nach Anspruch 1,
**dadurch gekennzeichnet,**
**dass** die Ausgangsgröße eine Schalterspannung (Uₓ) über den Schalter (10) ist und das Stellmittel zum Konstanthalten der Schalterspannung (Uₓ) über den Schalter (10) bei veränderlichem Strom durch den Schalter (10) vorgesehen ist.

3. Vorrichtung (2, 74) nach Anspruch 1 oder 2,
**dadurch gekennzeichnet,**
**dass** das Stellmittel (24) eine Regelschleife zum Konstanthalten der Ausgangsgröße umfasst.

4. Vorrichtung (2, 74) nach einem der vorhergehenden Ansprüche,
**dadurch gekennzeichnet,**
**dass** das Auswertemittel (28) dazu vorgesehen ist, aus der Ausgangsgröße einen Aktivitätszustand (42, 42a, 42b, 44, 46) des Schalters (10) zu ermitteln.

5. Vorrichtung (2, 74) nach Anspruch 4,
**dadurch gekennzeichnet,**
**dass** der Aktivitätszustand (42, 42a, 42b, 44, 46) ein Status des Schalters (10) ist.

6. Vorrichtung (2, 74) nach einem der vorhergehenden Ansprüche,
**dadurch gekennzeichnet,**
**dass** das Auswertemittel (28) dazu vorgesehen ist, die konstant gehaltene Ausgangsgröße zu überwachen und bei einer vorbestimmten Abweichung von der Konstanz ein Signal abzugeben.

7. Vorrichtung (2, 74) nach einem der vorhergehenden Ansprüche,
**dadurch gekennzeichnet,**
**dass** das Auswertemittel (28) zum Ermitteln des Laststroms (I) aus sowohl der Ausgangsgröße als auch der Steuergröße vorgesehen ist.

8. Vorrichtung (2, 74) nach einem der vorhergehenden Ansprüche,
**dadurch gekennzeichnet,**
**dass** der Schalter (10) ein Schalter (10) mit einer Kennlinie (40) ist und das Stellmittel (24) dazu vorgesehen ist, den Arbeitsbereich auf der Kennlinie (40) in Abhängigkeit vom Laststrom (I) einzustellen.

9. Vorrichtung (2, 74) nach Anspruch 8,
**dadurch gekennzeichnet,**
**dass** das Stellmittel (24) dazu vorgesehen ist, den Wert der konstant gehaltenen Ausgangsgröße bei Unterschreiten des Laststroms (I) unter einen vorbestimmten Wert abzusenken.

10. Vorrichtung (2, 74) nach einem der vorhergehenden Ansprüche,
**dadurch gekennzeichnet,**
**dass** der Schalter (10) parallel geschaltete Schaltelemente (12, 14) aufweist und Ausgangsgröße und Steuergröße beider Schaltelemente (12, 14) vom Auswertemittel (28) gleich behandelt werden.

11. Vorrichtung (74) nach einem der vorhergehenden Ansprüche,
**dadurch gekennzeichnet,**
**dass** im Stromkreis (I) eine aktive Diode (76) mit einer Sperrdiode (78) zum Schutz des Schalters (10) gegen Verpolung angeordnet ist.

12. Vorrichtung (74) nach Anspruch 11,
**dadurch gekennzeichnet,**
**dass** die aktive Diode (76) Teil eines weiteren Schalters bildet, der baugleich zum Schalter (10) zum Schalten des Laststroms (I) ist.

13. Vorrichtung (74) nach Anspruch 11 oder 12,
**gekennzeichnet**
**durch** ein Steuermittel (64), wobei die aktive Diode (76) einen Schalter (80) umfasst, der dazu vorgesehen ist, die Sperrdiode (78) zu überbrücken, und wobei das Steuermittel (64) dazu vorgesehen ist, den Schalter (80) in Abhängigkeit des vom Auswertemittel (28) gemessenen Stroms zu schalten.

14. Vorrichtung (74) nach Anspruch 13,
**dadurch gekennzeichnet,**
**dass** das Steuermittel (64) dazu vorgesehen ist, die Sperrdiode (78) bei einem Stromfluss durch den Lastkreis (4) ab einen vorbestimmten Grenzwert (G) zu überbrücken und den Schalter (80) bei einem Stromfluss unterhalb des Grenzwerts (G) zu öffnen.

## Claims

1. Apparatus (2,74) for measuring a load current (I) in a load circuit (4) having a switch (10) with a characteristic curve (40) which is intended to switch the load current (I) and has a control variable and an output variable, which is dependent on the control variable, a setting means (24) for keeping the output variable constant at a predetermined value, and an evaluation means (28) for determining the load current (I),
**characterized in that** the setting means (24) is intended to keep the output variable constant at a predetermined value in the case of variable current through the switch (10) and the evaluation means (28) is intended for determining the load current (I) from the control variable.

2. Apparatus (2,74) according to Claim 1,
**characterized in that**
the output variable is a switch voltage (U_{X}) across the switch (10), and the setting means is intended to keep the switch voltage (U_{X}) across the switch (10) constant in the case of variable current through the switch (10).

3. Apparatus (2,74) according to Claim 1 or 2,
**characterized in that**
the setting means (24) comprises a control loop for keeping the output variable constant.

4. Apparatus (2,74) according to one of the preceding claims,
**characterized in that**
the evaluation means (28) is intended to determine an activity state (42, 42a, 42b, 44, 46) of the switch (10) from the output variable.

5. Apparatus (2,74) according to Claim 4,
**characterized in that**
the activity state (42, 42a, 42b, 44, 46) is a status of the switch (10).

6. Apparatus (2,74) according to one of the preceding claims,
**characterized in that**
the evaluation means (28) is intended to monitor the output variable which is kept constant and to emit a signal in the case of a predetermined deviation from constancy.

7. Apparatus (2,74) according to one of the preceding claims,
**characterized in that**
the evaluation means (28) is intended to determine the load current (I) from both the output variable and the control variable.

8. Apparatus (2,74) according to one of the preceding claims,
**characterized in that**
the switch (10) is a switch (10) with a characteristic curve (40), and the setting means (24) is intended to set the operating range on the characteristic curve (40) as a function of the load current (I).

9. Apparatus (2,74) according to Claim 8,
**characterized in that**
the setting means (24) is intended to lower the value of the output variable, which is kept constant, when the load current (I) undershoots a predetermined value.

10. Apparatus (2,74) according to one of the preceding claims,
**characterized in that**
the switch (10) has switching elements (12, 14) which are connected in parallel, and the variable of both switching elements (12, 14) are treated the same by the evaluation means (28).

11. Apparatus (74) according to one of the preceding claims,
**characterized in that**
an active diode (76) having a blocking diode (78) for protecting the switch (10) against polarity reversal is arranged in the circuit (I).

12. Apparatus (74) according to Claim 11,
**characterized in that**
the active diode (76) forms part of a further switch which is structurally identical to the switch (10) for switching the load current (I).

13. Apparatus (74) according to Claim 11 or 12,
**characterized**
**by** a control means (64), the active diode (76) comprising a switch (80) which is intended to bridge the blocking diode (78), and the control means (64) being intended to switch the switch (80) on the basis of the current measured by the evaluation means (28).

14. Apparatus (74) according to Claim 13,
**characterized in that**
the control means (64) is intended to bridge the blocking diode (78) in the case of a current flow through the load circuit (4) as of a predetermined limit value (G) and to open the switch (80) in the case of a current flow below the limit value (G).

## Revendications

1. Dispositif (2, 74) de mesure d'un courant de charge (I) dans un circuit de charge (4) comportant un commutateur (10) présentant une courbe caractéristique (40), qui est prévu pour commuter le courant de charge (I) et comporte une grandeur de commande et une grandeur de sortie dépendant de la grandeur de commande, un moyen de réglage (24) destiné à maintenir constante la grandeur de sortie à une valeur prédéterminée, et un moyen d'évaluation (28) destiné à déterminer le courant de charge (I),
**caractérisé en ce que** le moyen de réglage (24) est prévu pour maintenir constante la grandeur de sortie à une valeur prédéterminée lorsque le courant passant à travers le commutateur (10) varie et **en ce que** le moyen d'évaluation (28) est prévu pour déterminer le courant de charge (I) à partir de la grandeur de commande.

2. Dispositif (2, 74) selon la revendication 1,
**caractérisé en ce que** la grandeur de sortie est une tension de commutateur (Uₓ) aux bornes du commutateur (10) et **en ce que** le moyen de réglage est prévu pour maintenir constante la tension de commutateur (Uₓ) aux bornes du commutateur (10) lorsque le courant passant à travers le commutateur (10) varie.

3. Dispositif (2, 74) selon la revendication 1 ou 2,
**caractérisé en ce que** le moyen de réglage (24) comprend une boucle de régulation destinée à maintenir constante la grandeur de sortie.

4. Dispositif (2, 74) selon l'une quelconque des revendications précédentes,
**caractérisé en ce que** le moyen d'évaluation (28) est prévu pour déterminer à partir de la grandeur de sortie un état d'activité (42, 42a, 42b, 44, 46) du commutateur (10).

5. Dispositif (2, 74) selon la revendication 4,
**caractérisé en ce que** l'état d'activité (42, 42a, 42b, 44, 46) est un état du commutateur (10).

6. Dispositif (2, 74) selon l'une quelconque des revendications précédentes,
**caractérisé en ce que** le moyen d'évaluation (28) est prévu pour surveiller la grandeur de sortie maintenue constante et pour délivrer un signal lors d'un écart prédéterminé par rapport à la valeur constante.

7. Dispositif (2, 74) selon l'une quelconque des revendications précédentes,
**caractérisé en ce que** le moyen d'évaluation (28) est prévu pour déterminer le courant de charge (I) tant à partir de la grandeur de sortie qu'à partir de la grandeur de commande.

8. Dispositif (2, 74) selon l'une quelconque des revendications précédentes,
**caractérisé en ce que** le commutateur (10) est un commutateur (10) présentant une courbe caractéristique (40) et **en ce que** le moyen de réglage (24) est prévu pour régler la zone de fonctionnement conformément à la courbe caractéristique (40) en fonction du courant de charge (I).

9. Dispositif (2, 74) selon la revendication 8,
**caractérisé en ce que** le moyen de réglage (24) est prévu pour réduire la valeur de la grandeur de sortie maintenue constante lorsque le courant de charge (I) s'abaisse en dessous d'une valeur prédéterminée.

10. Dispositif (2, 74) selon l'une quelconque des revendications précédentes,
**caractérisé en ce que** le commutateur (10) comporte des éléments de commutation (12, 14) connectés en parallèle et **en ce que** la grandeur de sortie et la grandeur de commande des deux éléments de commutation (12, 14) sont traitées de manière identique par le moyen d'évaluation (28).

11. Dispositif (74) selon l'une quelconque des revendications précédentes,
**caractérisé en ce qu'**une diode active (76) comportant une diode de blocage (78) destinée à protéger les commutateurs (10) contre une inversion de tension est disposée dans le circuit électrique (I).

12. Dispositif (74) selon la revendication 11,
**caractérisé en ce que** la diode active (76) fait partie d'un autre commutateur qui présente une structure identique à celle du commutateur (10) destiné à commuter le courant de charge (I).

13. Dispositif (74) selon la revendication 11 ou 12,
**caractérisé par** un moyen de commande (64) dans lequel la diode active (76) comprend un commutateur (80) qui est prévu pour contourner la diode de blocage (78) et dans lequel le moyen de commande (64) est prévu pour effectuer la commutation du commutateur (80) en fonction du courant mesuré par le moyen d'évaluation (28).

14. Dispositif (74) selon la revendication 13,
**caractérisé en ce que** le moyen de commande (64) est prévu pour contourner la diode de blocage (78) lorsque le courant passant à travers le circuit de charge (4) s'écarte d'une valeur limite déterminée (G) et pour ouvrir le commutateur (80) lors d'un courant inférieur à la valeur limite (G).
